# EUROPEAN PATENT APPLICATION

(11) **EP 3 029 662 A1**
(43) Date of publication of application: **08.06.2016**
(21) Application number: 13866488.3
(22) Date of filing: 18.10.2013
(51) Int. Cl.: G09G 3/36

(54) **SHIFT REGISTER UNIT AND DRIVE METHOD THEREOF, GATE DRIVE CIRCUIT AND DISPLAY DEVICE**

(30) Priority: 31.07.2013 CN 201310329312
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HU, Like, Beijing 100176 (CN); QI, Xiaojing, Beijing 100176 (CN)
(74) Representative: Brötz, Helmut
(86) International application number: PCT/CN2013/085521
(87) International publication number: WO 2015/014026

(57) **Abstract**

There is provided a shift register unit and driving method thereof, a gate driving circuit and display device. By setting the voltage stabilizing capacitor (C) connected to the pull-up node (P), the shift register unit utilizes the voltage stabilizing capacitor (C2) to stabilize the potential at the pull-up node (P), so as to make the signal output from the shift register unit more stable; and at the same time, uses a very small quantity of transistors and capacitors to compose the shift register unit, so that the wiring area of the gate driving circuit is greatly reduced to provide a technical support for the design of a liquid crystal display device with a narrower frame. In the meantime, since the structure of the gate driving circuit is simplified, the manufacturing process of the gate driving circuit is simplified and the cost for manufacturing is reduced. Further, the shift register unit quickly and effectively pulls down the output signal to the low potential through two pull-down processes, thereby enhancing the pull-down capability of the gate driving circuit.

## Description

### TECHNICAL FIELD

The present disclosure relates to the field of display technique, in particular to a shift register unit, a gate driving circuit for applying the shift register unit, a driving method for driving the shift register unit and a display device for applying the gate driving circuit.

### BACKGROUND

A thin film transistor liquid crystal display TFT-LCD is widely applied to electronic products such as a TV, a mobile phone, a display and so on due to its advantages of stable picture, vivid image, eliminating radiation, saving space and power consumption and so on, and has occupied a dominant position in the field of panel display .

A liquid crystal display panel is composed of matrix of pixels in horizontal and vertical directions. When the liquid crystal display panel displays, a gate scanning signal is output through a gate driving circuit to progressively scan respective pixels. Drivers of the liquid crystal display panel mainly include a gate driver and a data driver. The data driver latches an input display data and clock signal at regular time and in sequence, and converts them into an analogy signal to be inputted to a data line of the liquid crystal display panel. The gate driver converts the input clock signal through the shift register, switches it into an on/off voltage, and in sequence applies the voltage to a scanning gate line of the liquid crystal panel to gate the pixels, that is, the shift register in the gate driver is used for producing a scanning signal in the scanning gate line.

With the development of the panel display technique, narrow-framed products have attracted more and more attention. However, the shift register in the prior art generally uses a large quantity of transistors and other electrical elements, and it not only has a complex structure, but also occupies a large wiring area, which is disadvantageous for a narrow-framed design, and at the same time adds difficulty in manufacturing process of the shift register, thereby increasing the cost for manufacturing. Moreover, the size of the transistor generally cannot be too large because the transistor is always subjected to the limitation of the wiring space. In this way, there may be a problem of failing to quickly and effectively pull down the output signal to a low potential because of a too small size of a pull-down transistor. At the same time, in the shift register unit of the prior art, since a control signal for a pull-up transistor is directly inputted to the pull-up transistor, a switch control over the pull-up transistor may be affected, thereby causing the output signal of the shift register unit unstable.

### SUMMARY

The technical problem to be solved in the present disclosure is, in view of the existing technology deficiencies, to provide a shift register unit having a more stable output signal, a gate driving circuit for applying the shift register unit, a driving method for driving the shift register unit and a display device for applying the gate driving circuit, which uses a very small quantity of transistors, so that the wiring area of the gate driving circuit is greatly reduced, so as to provide a technical support for the design of the a liquid crystal display device with a narrower frame and further enhance the pull-down capability of the whole shift register unit, thereby increasing the response speed of the liquid crystal display device.

The present disclosure has the following technical solutions.

A shift register unit comprises:
a pull-up module connected to a first clock signal input terminal, a signal output terminal and a pull-up node respectively for outputting a signal inputted from the first clock signal input terminal to the signal output terminal according to a potential at the pull-up node, the pull-up node being a connecting point between the pull-up module and a pull-up driving module;
a pull-down module connected to the signal output terminal, a first signal terminal and a second clock signal input terminal respectively for pulling down a potential at the signal output terminal to the first signal terminal according to a signal output from the second clock signal input terminal;
the pull-up driving module connected to a signal input terminal and the pull-up node respectively for driving the pull-up module according to a signal inputted from the signal input terminal;
a reset module connected to a second signal terminal, a reset signal terminal and the pull-up node respectively for resetting a signal at the pull-up node according to a signal inputted from the reset signal terminal;
a voltage stabilizing module connected to the pull-up node for stabilizing the potential at the pull-up node.

Alternatively, the reset signal terminal is connected to the second clock signal input terminal.

Alternatively, the second signal terminal and the first signal terminal are at a low level; and the potential at the second signal terminal is lower than the potential at the first signal terminal.

Alternatively, the pull-up driving module comprises a pull-up driving transistor, the reset module comprises a reset transistor, the pull-up module comprises a pull-up transistor and a bootstrap capacitor, the pull-down module comprises a pull- down transistor, and the voltage stabilizing module comprises a voltage stabilizing capacitor;
the pull-up driving transistor has a gate and a drain connected to the signal input terminal, and a source connected to a drain of the reset transistor, a first terminal of the voltage stabilizing capacitor, a first terminal of the bootstrap capacitor and a gate of the pull-up transistor respectively;
the reset transistor has a gate connected to the reset signal terminal ,and a source connected to a second terminal of the voltage stabilizing capacitor and the second signal terminal respectively;
the pull-up transistor has a drain connected to the first clock signal input terminal, and a source connected to the signal output terminal, a second terminal of the bootstrap capacitor and a drain of the pull-down transistor respectively;
the pull-down transistor has a gate connected to the second clock signal input terminal and a source connected to the first signal terminal.

Alternatively, all the transistors are N-channel type transistors or all the transistors are P-channel type transistors.

According to another aspect of the present disclosure, there is further provided a driving method for driving the above shift register unit:
a driving method for driving a shift register unit comprises the following steps:
in a charging stage, inputting a previous stage of output signal or a start signal from a signal input terminal to turn on a pull-up driving transistor and a pull-up transistor, inputting a clock signal from a reset signal terminal to turn off a reset transistor, and charging a voltage stabilizing capacitor and a bootstrap capacitor by the previous stage of output signal or the start signal;
in an outputting stage, ending signal input at the signal input terminal to turn off the pull-up driving transistor, and inputting a clock signal from a second clock signal input terminal to turn off the pull-down transistor; continuously turning on the pull-up transistor, raising a potential at a pull-up node by the bootstrap capacitor through a clock signal inputted from a first clock signal input terminal, maintaining the potential at the pull-up node by the voltage stabilizing capacitor, and outputting the clock signal inputted from the first clock signal input terminal to a signal output terminal by the pull-up transistor;
in a resetting stage, inputting a clock signal from the reset signal terminal to control the reset transistor and the pull-down transistor to be turned on, pulling down the potential at the pull-up node by the reset transistor to turn off the pull-up transistor, and pulling down a potential at a signal output terminal by the pull-down transistor.

Alternatively, the reset signal input terminal is connected to the second clock signal input terminal.

According to another aspect of the present disclosure, there is further provided a gate driving circuit comprising any one of the above shift register units:
a gate driving circuit comprising any one of the above shift register units; except a last stage of shift register unit, a signal output terminal of each of other shift register units is connected to a signal input terminal of a next stage of shift register unit, and a signal input terminal of a first stage of shift register unit is connected to a start signal.

According to another aspect of the present invention, there is further provided a display device comprising the above gate driving circuit.

By setting the voltage stabilizing capacitor connected to the pull-up node, the shift register unit provided in the embodiments of the present disclosure utilizes the voltage stabilizing capacitor to stabilize the potential at the pull-up node, so as to make the signal output from the shift register unit more stable; at the same time, the present disclosure uses a very small quantity of transistors and capacitors to compose the shift register unit, so that the wiring area of the gate driving circuit is greatly reduced, so as to provide a technical support for the design of a liquid crystal display device with a narrower frame. In the meantime, since the structure of the gate driving circuit is simplified, the manufacturing process of the gate driving circuit is simplified and the cost for manufacturing is reduced. Further, the shift register unit provided in the present disclosure quickly and effectively pulls down the output signal to the low potential through two pull-down processes, thereby enhancing the pull-down capability of the gate driving circuit.

### BRIEF DESCRIPTION OF THE DRAWINGS

Fig.1 is a schematic diagram of a module connection of a shift register unit in a first embodiment of the present disclosure;
Fig.2 is a circuit diagram of an implementation of a shift register unit in a first embodiment of the present disclosure;
Fig.3 is a circuit diagram of another implementation of a shift register unit in a first embodiment of the present disclosure;
Fig.4 is a schematic diagram of a structure of a gate driving circuit in a first embodiment of the present disclosure;
Fig.5 is a schematic diagram of driving timing and signal waveform of the shift register unit in Fig.2;
Fig.6 is a schematic diagram of a module connection of a shift register unit in a second embodiment of the present disclosure;
Fig.7 is a circuit diagram of an implementation of a shift register unit in a second embodiment of the present disclosure;
Fig.8 is a circuit diagram of another implementation of a shift register unit in a second embodiment of the present disclosure;
Fig.9 is a schematic diagram of a structure of a gate driving circuit in a second embodiment of the present disclosure;
Fig.10 is a schematic diagram of driving timing and signal waveform of the shift register unit in Fig.7;

### DETAILED DESCRIPTION

Specific implementations of the present disclosure will be further described below in combination with the accompanying figures and embodiments. The following embodiments are just used for specifying the present disclosure rather than being used to limit the scope of the disclosure.

### First Embodiment

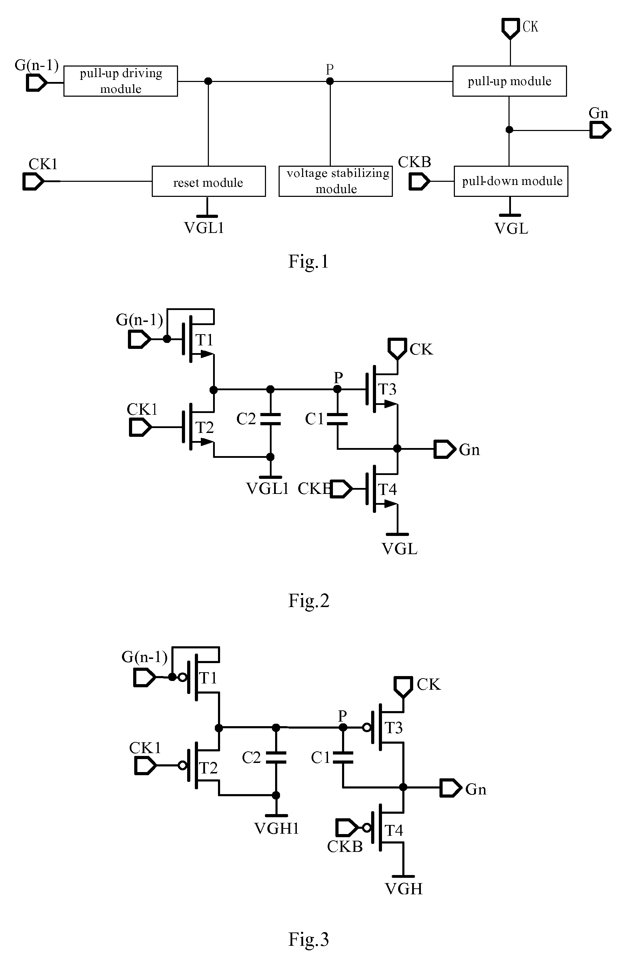

As shown in Fig.1, a shift register unit provided in the present embodiment mainly comprises: a pull-up module connected to a first clock signal input terminal, a signal output terminal and a pull-up node P respectively for outputting a signal inputted from the first clock signal input terminal to the signal output terminal according to a potential at the pull-up node P; a pull-down module connected to the signal output terminal, a first signal terminal and a second clock signal input terminal respectively for pulling down a potential at the signal output terminal according to a signal output from the second clock signal input terminal; a pull-up driving module connected to a signal input terminal and the pull-up node P respectively for driving the pull-up module according to a signal inputted from the signal input terminal; a reset module connected to a second signal terminal, a reset signal terminal and the pull-up node P respectively for resetting a signal at the pull-up node P according to a signal inputted from the reset signal terminal; a voltage stabilizing module connected to the pull-up node P for stabilizing the potential at the pull-up node P. By setting the voltage stabilizing capacitor connected to the pull-up node P, the shift register unit utilizes the voltage stabilizing capacitor to stabilize the potential at the pull-up node P, so as to make the signal output from the shift register unit more stable.

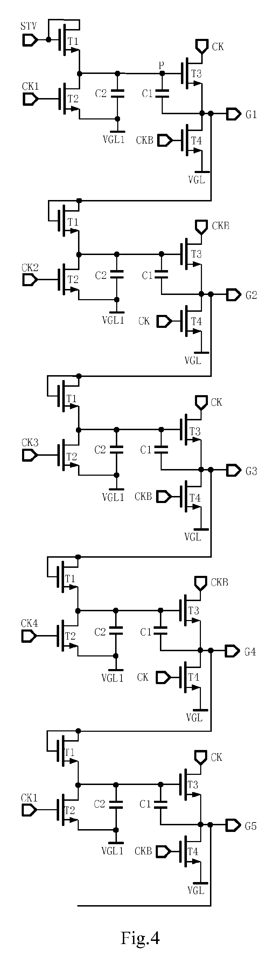

The circuit shown in Fig.2 is a specific implementation of the shift register unit provided in the present embodiment. Fig.4 is a gate driving circuit composed of the shift register unit in Fig.2. As shown in Fig.2, the shift register unit in the present embodiment comprises a pull-up driving transistor T1, a reset transistor T2, a pull-up transistor T3, a pull-down transistor T4, a bootstrap capacitor C1 and a voltage stabilizing capacitor C2, and further comprises a signal input terminal, a signal output terminal, a first clock signal input terminal, a second clock signal input terminal, a reset signal terminal, a second signal terminal VGL1 and a first signal terminal VGL. As shown in Fig.4, in the gate driving circuit of the present embodiment, except for the first stage of shift register unit, a signal input terminal of each stage of other shift register units is connected to a signal output terminal of the previous stage of shift register unit; except for the last stage of shift register unit, a signal output terminal of each stage of other shift register units is connected to a signal input terminal of the next stage of shift register unit, and a signal input terminal of the first stage of shift register unit is connected to a start signal STV. In the present embodiment, the pull-up driving transistor T1 has a gate and a drain connected to the signal input terminal, and a source connected to a drain of the reset transistor T2, a first terminal of the voltage stabilizing capacitor C2, a first terminal of the bootstrap capacitor C1 and a gate of the pull-up transistor T3 respectively, when there is inputted the start signal STV or the output signal of previous stage , the pull-up driving transistor T1 is turned on to charge the voltage stabilizing capacitor C2 and the bootstrap capacitor C1; the reset transistor T2 has a gate connected to the reset signal terminal, and a source connected to a second terminal of the voltage stabilizing capacitor C2 and the second signal terminal VGL1 respectively, wherein after the signal output at the signal output terminal is completed, the reset transistor T2 is turned on under the control of the reset signal to reset the shift register unit; the pull-up transistor T3 has a drain connected to the first clock signal input terminal, and a source connected to the signal output terminal, a second terminal of the bootstrap capacitor C1 and a drain of the pull-down transistor T4 respectively, and is used for providing the output signal to the signal output terminal; the pull-down transistor T4 has a gate connected to the second clock signal input terminal, and a source connected to the first signal terminal VGL, and is used for pulling down the output signal at the signal output terminal; the voltage capacitor C2 is used for stabilizing the potential at the pull-up node P (i.e., a gate connecting point of the pull-up transistor T3) after the signal input at the signal input terminal is completed, so as to make the output terminal more stable; the bootstrap capacitor C1 is used for raising the potential at the pull-up node, so that the potential at the pull-up node is higher than the potential at the first clock signal input terminal, so as to make the first clock signal output completely; the second signal terminal VGL1 and the first signal terminal VGL are all at a low level. In the present embodiment, in order to more completely turn off the pull-up transistor T3 and reduce a leakage current of the pull-up transistor T3, the potential at the second signal terminal VGL1 is lower than the potential at the first signal terminal VGL.

Another advantage of the shift register unit and the gate driving circuit in the present embodiment is adopting a single-channel type of transistor, that is, all the transistors are N-channel type transistors, thereby further reducing the complexity of the manufacturing process and the production cost. Of course, it is easy for those skilled in the art to obtain that the shift register unit provided in the present disclosure can be easily changed into all the transistors being P-channel type transistors, in particular as shown in Fig.3, which is not limited to the implementations provided in the present embodiment, and will not be described repeatedly herein.

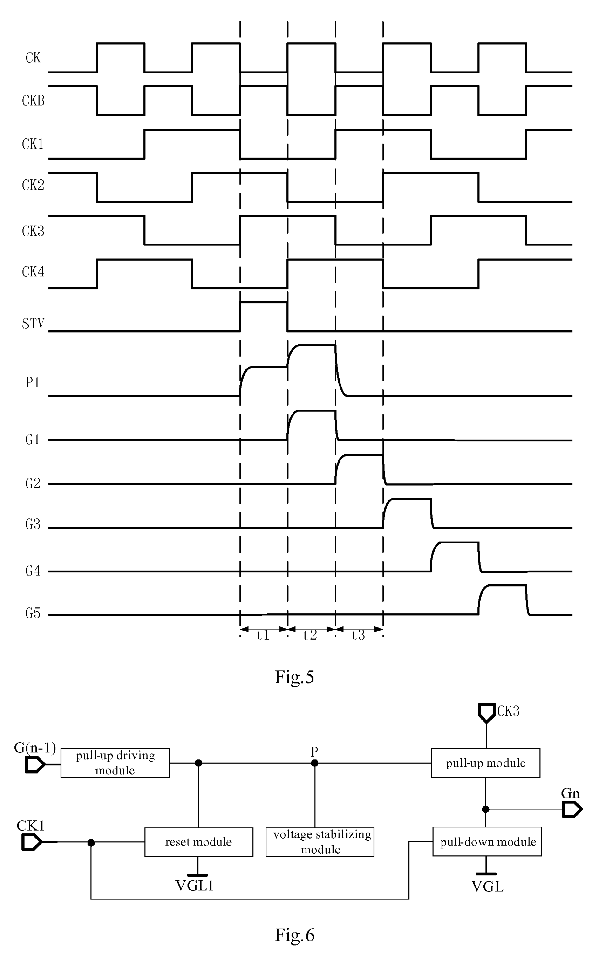

The present embodiment further provides a driving method for driving the above shift register unit. Referring to the driving timing diagram in Fig.5, all the transistors therein are N-channel type transistors, a clock signal CK1 is taken as a signal output from the reset signal terminal, and a clock signal CK is taken as a signal output from the first clock signal input terminal; a pulse width of the clock signal CK1 is two times of that of the clock signal CK and the start signal STV, and phase difference between the adjacent clock signals is 90 degrees. As such, the gate driving circuit comprising the above shift register unit needs four clock signals CK1∼CK4. By adding the clock signal CK and the clock signal CKB, the gate driving circuit totally needs six clock signals. The operating process of the method for driving the shift register unit mainly comprises the following stages:

in a charging stage t1, the signal input terminal inputs a previous stage of output signal G(n-1) or the start signal STV, the potential at the pull-up node P is raised, the pull-up driving transistor T1 and the pull-up transistor T3 are turned on, the reset signal terminal inputs a low level signal to turn off the reset transistor T2, the second clock signal input terminal inputs a high level signal to turn on the pull-down transistor T4, the previous stage of output signal G(n-1) or the start signal STV charges the voltage stabilizing capacitor C2 and the bootstrap capacitor C1, and a signal output terminal Gn outputs the low level signal.

in a outputting stage t2, the signal input at the signal input terminal is ended, the pull-up driving transistor T1 is turned off, the second clock signal input terminal outputs the low level signal, and the pull-down transistor T4 is turned off; the first clock signal input terminal outputs the high level signal , the bootstrap capacitor C1 continuously raises the potential at the pull-up node P, the voltage stabilizing capacitor C2 maintains the potential at the pull-up node, and the pull-up transistor T3 completely outputs the high level signal at the first clock input terminal to the signal output terminal Gn;

in a resetting stage t3, the reset signal terminal outputs the high level signal, the reset transistor T2 and the pull-down transistor T4 are turned on, the second signal terminal VGL1 pulls down the potential at the pull-up node P, the pull-up transistor T3 is turned off, the second clock signal input terminal outputs the high level signal, the pull-down transistor T4 is turned on, and the potential at the signal output terminal Gn is pulled down to the potential at the first signal terminal VGL.

Since the potential at the second signal terminal VGL1 is lower that the potential at the first signal terminal VGL. As such, when the output signal is pulled down, the voltage at the pull-up node P is pulled down to the potential at the second signal terminal VGL1, and the voltage at the signal output terminal is pulled down to the potential at the first signal terminal VGL. Since VGL1 is smaller than VGL, the gate-source voltage VGS of the pull-up transistor T3 is smaller than 0, so that there will be a more complete turn-off and a smaller leakage current.

The embodiment of the present disclosure further provides a display device comprising the above gate driving circuit; since the used gate driving circuit has a smaller wiring area, the frame of the display device can be made to be narrower.

### Second Embodiment

As shown in Fig.6, a shift register unit provided in the embodiment 2 mainly comprises: a pull-up module connected to a first clock signal input terminal, a signal output terminal and a pull-up node P respectively for outputting a signal inputted from the first clock signal input terminal to the signal output terminal according to a potential at the pull-up node P; a pull-down module connected to the signal output terminal, a first signal terminal and a second clock signal input terminal respectively for pulling down a potential at the signal output terminal according to a signal output from the second clock signal input terminal; a pull-up driving module connected to a signal input terminal and the pull-up node P respectively for driving the pull-up module according to a signal inputted from the signal input terminal; a reset module connected to a second signal terminal, a second clock signal input terminal and the pull-up node P respectively for resetting a signal at the pull-up node P according to a signal inputted from the second clock signal input terminal; a voltage stabilizing module connected to the pull-up node P for stabilizing the potential at the pull-up node P. By setting the voltage stabilizing capacitor connected to the pull-up node P, the shift register unit utilizes the voltage stabilizing capacitor to stabilize the potential at the pull-up node P, so as to make the signal output from the shift register unit more stable.

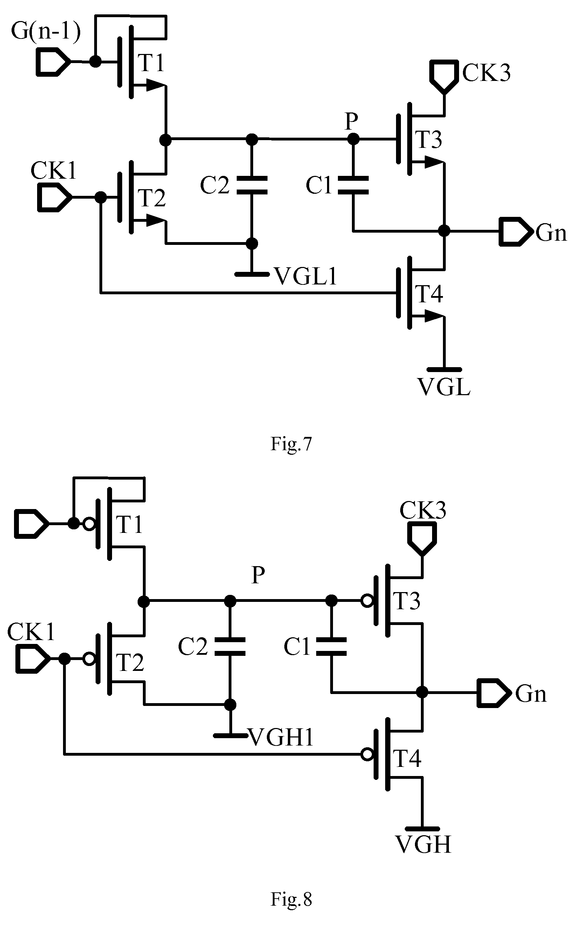

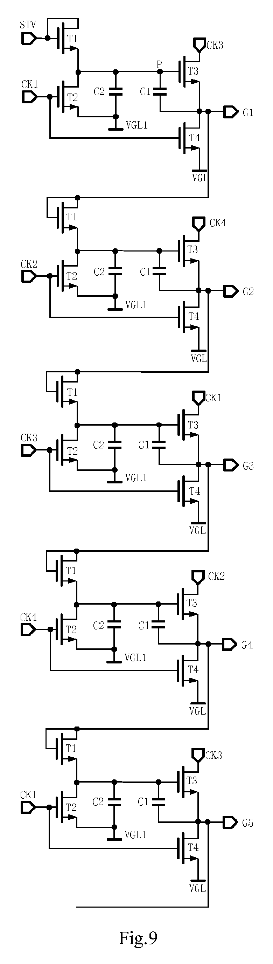

The circuit shown in Fig.7 is a specific implementation of the shift register unit provided in the present embodiment. Fig.9 is a gate driving circuit composed of the shift register unit in Fig.7. As shown in Fig.7, the shift register unit in the present embodiment comprises a pull-up driving transistor T1, a reset transistor T2, a pull-up transistor T3, a pull-down transistor T4, a bootstrap capacitor C1 and a voltage stabilizing capacitor C2, and further comprises a signal input terminal, a signal output terminal, a first clock signal input terminal, a second clock signal input terminal, a second signal terminal VGL1 and a first signal terminal VGL. As shown in Fig.9, in the gate driving circuit of the present embodiment, except for the first stage of shift register unit, a signal input terminal of each stage of other shift register units is connected to a signal output terminal of a previous stage of shift register unit; except for the last stage of shift register unit, a signal output terminal of each stage of other shift register units is connected to a signal input terminal of the next stage of shift register unit, and a signal input terminal of the first stage of shift register unit is connected to a start signal STV. In the present embodiment, the pull-up driving transistor T1 has a gate and a drain connected to the signal input terminal, and a source connected to a drain of the reset transistor T2, a first terminal of the voltage stabilizing capacitor C2, a first terminal of the bootstrap capacitor C1 and a gate of the pull-up transistor T3 respectively, wherein when there is inputted the start signal STV or the output signal of the previous stage , the pull-up driving transistor T1 is turned on to charge the voltage stabilizing capacitor C2 and the bootstrap capacitor C1; the reset transistor T2 has a gate connected to the second clock signal input terminal, and a source connected to a second terminal of the voltage stabilizing capacitor C2 and the second signal terminal VGL1 respectively, wherein after the signal output at the signal output terminal is completed, the reset transistor T2 is turned on under the control of the second clock signal to reset the shift register unit; the pull-up transistor T3 has a drain connected to the first clock signal input terminal, and a source connected to the signal output terminal, a second terminal of the bootstrap capacitor C1 and a drain of the pull-down transistor T4 respectively, and is used for providing the output signal to the signal output terminal; the pull-down transistor T4 has a gate connected to the second clock signal input terminal, and a source connected to the first signal terminal VGL, and is used for pulling down the output signal at the signal output terminal; the voltage capacitor C2 is used for stabilizing the potential at the pull-up node (i.e., gate connecting point of the pull-up transistor T3) after the signal input at the signal input terminal is completed, so as to make the output terminal more stable; the bootstrap capacitor C1 is used for raising the potential at the pull-up node, so that the potential at the pull-up node is higher than the potential at the first clock signal input terminal, so as to make the first clock signal output completely; the second signal terminal VGL1 and the first signal terminal VGL are at a low level. In the present embodiment, in order to more completely turn off the pull-up transistor T3 and reduce a leakage current of the pull-up transistor T3, the potential at the second signal terminal VGL1 is lower than the potential at the first signal terminal VGL.

Another advantage of the shift register unit and the gate driving circuit in the present embodiment is adopting a single channel type of transistor, that is, all the transistors are N-channel type transistors, thereby further reducing the complexity of the manufacturing process and the production cost. Of course, it is easy for those skilled in the art to obtain that the shift register unit provided in the present disclosure can be easily changed into all the transistors being P-channel type transistors, in particular as shown in Fig.8, which is not limited to the implementation provided in the present embodiment, thereby details omitted herein.

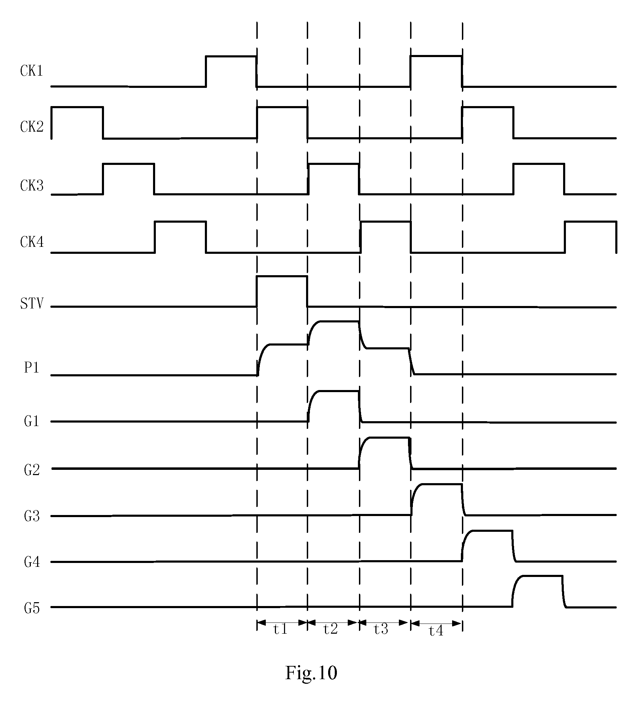

The present embodiment further provides a driving method for driving the above shift register unit. Referring to the driving timing diagram in Fig.10, all the transistors therein are N-channel type transistors, a clock signal CK1 is taken as a signal inputted from the second clock signal input terminal, and a clock signal CK3 is taken as a signal inputted from the first clock signal input terminal; a pulse width of the clock signal CK1 and the clock signal CK3 is the same as that of the start signal STV. The clock signal CK1 is not actuated until the start signal STV at the same stage in the gate driving circuit comprising the above shift register unit has passed three of times, and phase difference between the adjacent clock signals is 90 degrees. As such, the whole gate driving circuit needs four clock signals CK1∼CK4. The operating process of the method for driving the shift register unit mainly comprises the following stages:

in a charging stage t1, the signal input terminal inputs a previous stage of output signal G(n-1) or the start signal STV, the potential at the pull-up node P is raised, the pull-up driving transistor T1 and the pull-up transistor T3 are turned on, the second signal input terminal inputs a low level signal to turn off the reset transistor T2 and the pull-down transistor T4, the previous stage of output signal G(n-1) or the start signal STV charges the voltage stabilizing capacitor C2 and the bootstrap capacitor C1, and a signal output terminal Gn outputs the low level signal.

in an outputting stage t2, the signal input at the signal input terminal is ended, the pull-up driving transistor T1 is turned off, the second clock signal input terminal inputs the low level signal, and the pull-down transistor T4 is turned off; the first clock signal input terminal inputs the high level signal , the bootstrap capacitor C1 raises the potential at the pull-up node P, the voltage stabilizing capacitor C2 maintains the potential at the pull-up node, and the pull-up transistor T3 completely outputs the high level signal at the first clock input terminal to the signal output terminal Gn;
a resetting stage including a first stage t3 and a second stage t4:
in a first stage t3: the first clock signal input terminal inputs the low level signal; at this time, the reset transistor T2 and the pull-down transistor T4 are still turned off, the pull-up transistor T3 is still turned on, and the low level signal inputted from the first clock signal input terminal pulls down the potential at the pull-up node P; although the potential at the pull-up node P is decreased, this potential can still turn on the pull-up transistor T3 to make the low level signal at the first clock signal input terminal output completely;
in a second stage t4: the second clock input terminal inputs the high level signal, the reset transistor T2 and the pull-down transistor T4 are turned on to again pull down the potential at the pull-up node P to the potential at the second signal terminal VGL1 to turn off the pull-up transistor T3, the potential at the signal output terminal is pulled down to the potential at the first signal terminal VGL, and the turn-on of the pull-down transistor T4 again ensures to pull down the potential at the signal output terminal to the potential at the first signal terminal VGL.

Since the potential at the second signal terminal VGL1 is lower that the potential at the first signal terminal VGL, when the output signal is pulled down, the voltage at the pull-up node P is pulled down to the potential at the second signal terminal VGL1, and the voltage at the signal output terminal is pulled down to the potential at the first signal terminal VGL. Since VGL1 is smaller than VGL, the gate-source voltage VGS of the pull-up transistor T3 is below 0, so that there will be a more complete turn-off and a smaller leakage current.

The embodiment 1 uses 6 groups of clock signals while the embodiment 2 only uses 4 groups of clock signals; in embodiment 1, the pull-up transistor 3 only functions as pulling up while in embodiment 2, the pull-up transistor T3 immediately pulls down the output signal after pulling up, and further again pulls down the output signal through the pull-down transistor T4 at the next time, such that the pull-down capability of the whole gate driving circuit is greatly enhanced.

The embodiment of the present disclosure further provides a display device comprising the above gate driving circuit; since the used gate driving circuit has a smaller wiring area, the frame of the display device can be made to be narrower; further, since the pull-down capability of the whole gate driving circuit is enhanced, the response speed of the liquid crystal display device is increased.

The above embodiments are just used for specifying the present disclosure rather than limiting the present disclosure. Those skilled in the art can make various alternations and modifications without departing from the spirit and scope of the present disclosure, and thereby all equivalent technical solutions belong to the protection scope of the present disclosure.

## Claims

1. A shift register unit comprising:
a pull-up module connected to a first clock signal input terminal, a signal output terminal and a pull-up node respectively, for outputting a signal inputted from the first clock signal input terminal to the signal output terminal according to a potential at the pull-up node, the pull-up node being a connecting point between the pull-up module and a pull-up driving module;
a pull-down module connected to the signal output terminal, a first signal terminal and a second clock signal input terminal respectively, for pulling down a potential at the signal output terminal to the first signal terminal according to a signal output from the second clock signal input terminal;
a pull-up driving module connected to a signal input terminal and the pull-up node respectively, for driving the pull-up module according to a signal inputted from the signal input terminal;
a reset module connected to a second signal terminal, a reset signal terminal and the pull-up node respectively, for resetting a signal at the pull-up node according to a signal inputted from the reset signal terminal; and
a voltage stabilizing module connected to the pull-up node, for stabilizing the potential at the pull-up node.

2. The shift register unit according to claim 1, wherein the reset signal terminal is connected to the second clock signal input terminal.

3. The shift register unit according to claim 1, wherein the first signal terminal and the second signal terminal are both at a low level; and the potential at the second signal terminal is lower than the potential at the first signal terminal.

4. The shift register unit according to any one of claims 1-3, wherein the pull-up driving module comprises a pull-up driving transistor, the reset module comprises a reset transistor, the pull-up module comprises a pull-up transistor and a bootstrap capacitor, the pull-down module comprises a pull-down transistor, and the voltage stabilizing module comprises a voltage stabilizing capacitor;
a gate and a drain of the pull-up driving transistor is connected to the signal input terminal, and a source of the pull-up driving transistor is connected to a drain of the reset transistor, a first terminal of the voltage stabilizing capacitor, a first terminal of the bootstrap capacitor and a gate of the pull-up transistor respectively;
a gate of the reset transistor is connected to the reset signal terminal, and a source of the reset transistor is connected to a second terminal of the voltage stabilizing capacitor and the second signal terminal respectively;
a drain of the pull-up transistor is connected to the first clock signal input terminal, and a source of the pull-up transistor is connected to the signal output terminal, a second terminal of the bootstrap capacitor and a drain of the pull-down transistor respectively; and
a gate of the pull-down transistor is connected to the second clock signal input terminal and a drain of the pull-down transistor is connected to the first signal terminal.

5. The shift register unit according to claim 4, wherein all the transistors are N-channel type transistors or all the transistors are P-channel type transistors.

6. A driving method for driving the shift register unit according to claim 1, comprising the following steps:
in a charging phase, inputting an output signal of a previous stage or a start signal from a signal input terminal to turn on a pull-up driving transistor and a pull-up transistor, inputting a clock signal from a reset signal terminal to turn off a reset transistor, and charging a voltage stabilizing capacitor and a bootstrap capacitor by the output signal of the previous stage or the start signal;
in an outputting stage, ending signal input at the signal input terminal to turn off the pull-up driving transistor, and inputting a clock signal from a second clock signal terminal to turn off the pull-down transistor, continuously turning on the pull-up transistor, raising a potential at a pull-up node by the bootstrap capacitor through a clock signal inputted from a first clock signal input terminal, maintaining the potential at the pull-up node by the voltage stabilizing capacitor, and outputting a signal at the first clock signal input terminal to a signal output terminal by the pull-up transistor; and
in a resetting stage, inputting a clock signal from the reset signal terminal to control the reset transistor and the pull-down transistor to be turned on, pulling down the potential at the pull-up node by the reset transistor to turn off the pull-up transistor, and pulling down a potential at a signal output terminal by the pull-down transistor.

7. The method for driving the shift register unit according to claim 6, wherein the reset signal input terminal is connected to the second clock signal input terminal.

8. A gate driving circuit comprising multiple shift register units according to any one of claims 1-5, except for a last stage of shift register unit, a signal output terminal of each stage of other shift register units is connected to a signal input terminal of a next stage of shift register unit, and a signal input terminal of a first stage of shift register unit is connected to a start signal.

9. A display device comprising the gate driving circuit according to claim 8.
